(19) Europäisches Patentamt
European Patent Office
Office européen des brevets

(11) **EP 4 379 962 A1**

(12) **EUROPEAN PATENT APPLICATION**

(43) Date of publication:
05.06.2024 Bulletin 2024/23

(51) International Patent Classification (IPC):
*H01R 11/18* (2006.01)       *H01R 13/66* (2006.01)

(21) Application number: 23212847.0

(22) Date of filing: 29.11.2023

(52) Cooperative Patent Classification (CPC):
H01R 13/6683; B60L 53/18; G01K 7/16;
G01K 7/42; G01R 31/00; H01R 11/18;
H01R 2201/26

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 29.11.2022 DE 102022131544

(71) Applicant: TE Connectivity Solutions GmbH
8200 Schaffhausen (CH)

(72) Inventors:
• LUDWIG, Michael
8200 Schaffhausen (CH)
• LEIDNER, Michael
8200 Schaffhausen (CH)
• SCHMIDT, Helge
8200 Schaffhausen (CH)
• BERGER, Christian
8200 Schaffhausen (CH)

(74) Representative: Grünecker Patent- und
Rechtsanwälte
PartG mbB
Leopoldstraße 4
80802 München (DE)

(54) **CONNECTOR HAVING AN OUTPUT UNIT FOR CONNECTION TO AN EVALUATION UNIT FOR DETERMINING A TEMPERATURE OF A CONTACT POINT AND METHOD FOR DETERMINING A TEMPERATURE OF A CONTACT POINT OF A CONNECTOR**

(57) This document relates to a connector (100) for determining a temperature ($T_{contact}$) of a contact point. The connector (100) comprises a connector contact element (110, 110') for electrically contacting the connector (100) with a mating connector contact element (210) of a mating connector (200) at the contact point. Furthermore, the connector comprises a connector tap (160, 160') for tapping a connector potential (V1) at the connector contact element (110, 110') and a mating connector contact probe (170, 170') for determining a mating connector potential (V2) of the mating connector contact element (210). Thus, it is possible to determine the temperature ($T_{contact}$) of the contact point from a potential difference (U) between the connector potential (V1) and the mating connector potential (V2).

Fig. 1

EP 4 379 962 A1

**Description**

The invention relates to a connector having an output unit for connection to an evaluation unit for determining a temperature of a contact point, and a method for determining a temperature of a contact point of a connector.

High-performance connectors are used to transmit power. Especially in the field of renewable energies and electro mobility, there is a need to transmit high power in a short time, for example to quickly charge the battery of an electric vehicle (EV), to supply the motor of an EV with high power, or to connect an energy storage device to the grid at short notice. In particular, there may be applications where currents > 100 A are transmitted.

A connector has a contact point between the plug and mating connector. The contact point here is the area where a connector contact element of the connector makes electrical contact with a mating connector contact element of the mating connector. This contact area usually has a cross-section that is smaller than the conductor cross-section of the connector contact element and mating connector contact element. As a result, the resistance in the contact point is usually highest. This also means that the temperature is usually highest at the contact point.

The temperature in the contact point can be measured indirectly, for example by a temperature sensor located close to the contact point. However, this indirect measurement is unsatisfactory because, for example, degradation of the contact point on the mating connector or on the connector can degrade the contact point and thus represent a potential source of error. Indirect temperature measurement, however, is slow due to the spatial distance between the sensor and the contact point. Thus, both contact elements can melt at the contact point before an over temperature is even detected.

In the case of a regularly to be disconnected connection, such as the charging part of an electric vehicle, damage occurs to both contact partners, which can propagate further. In other words, a chain reaction occurs and the degradation spreads from connector to mating connector. This is especially problematic for EVs, since a large number of EVs access a large number of charging stations. Thus, one degradation can quickly damage a large number of EVs and charging stations.

It is the task of the present invention to overcome the above disadvantages. It is a task of the invention to quickly detect an over temperature. Further, it is a task to accurately determine an over temperature. Further, it is a task to provide all means for determining the over temperature at one of the connector or the mating connector.

The above tasks are solved by the subject matter of the independent patent claims. Advantageous further developments are the subject of the dependent patent claims.

In particular, the task is solved by a connector tap and/or a mating connector contact probe, whereby a connector potential at the connector contact element and/or a mating connector potential of the mating connector contact element can be determined. From the potential difference, the temperature at the contact point can be determined directly. It thus results that through the relationship between a potential difference the temperature in the contact point can be directly determined.

According to a first example, for determining a temperature of a contact point, the connector comprises a connector contact element for electrically contacting the connector with a mating connector contact element of a mating connector. The connector contact element and mating connector contact element come into electrical contact at the contact point.

In this document, a connector is understood to be a part for separating and connecting electrical wires. The connector interacts with a mating connector. The connecting parts, i.e. the connector and the mating connector, can be aligned by positive locking forces and can be fixed in a detachable manner.

In the case of electrical plug connections, a distinction can be made between the male part (with contact pins pointing outwards) and the female part (with contact openings pointing inwards). Here, contact pins and contact openings are referred to as contact elements. In particular, the connector contact element may be either the male part or the female part, for example containing outwardly facing contact pins or inwardly facing contact openings. Accordingly, mating connector contact element may be either the female part or the male part. There are also connectors with contact elements of both genders.

The connector contact element and the mating connector contact element come into electrical contact by being plugged at the contact point. The so-called contact resistance prevails in the contact point. The contact resistance is made up in particular of the sum of the two components of constriction resistance and impurity resistance.

The constriction resistance is caused by the microscopic unevenness of a contact surface. The effective contact area is therefore smaller and the current flow is restricted. The constriction resistance depends in particular on the resistivity of the material used, the surface unevenness (e.g. caused by burn-off) and the number of effective contact areas. The size of the contact point results from the contact normal force and the hardness or strength of the surface material.

Corrosion (e.g. oxidation) creates an impurity layer on the contact surface which increases the resistance, i.e. an impurity resistance. To avoid this, precious metals such as gold, silver, palladium or platinum are used, often only in thin layers. The connector contact element and the mating connector contact element can also have such corrosion-resistant coatings.

Mechanical stress, for example repeated mating, and time can change the contact resistance. For example, the constriction resistance can change due to mechanical stress. Furthermore, corrosion-resistant layers can be removed or damaged, resulting in a change in the impurity resistance.

There is now a link between the electric voltage and the temperature in a current-carrying conductor. The relationship of Kohlrausch and Diesselhorst is based on the assumption that the surfaces of equal potential are at the same time surfaces of constant temperature and that no thermoelectric effects occur. This relation can be applied to electrical contacts. In a simplified case (neglect of micro-roughness and contact pieces free of impurity layers), a maximum temperature can be determined by the following relation:

$$T_{Contact} = \frac{U^2}{8\rho\lambda} + T_1 \text{ Formula (1)}$$

with $T_{Contact}$ the temperature of the contact surface, $T_1$ the temperature at a remote point in the contact piece, $U$ the constriction voltage between the contact surface and this remote point, $\rho$ the resistivity of the contact material, and $\lambda$ the thermal conductivity of the contact material.

This relationship allows the temperature in the contact area to be directly determinable. In particular, according to the first example, the connector may include a connector tap for tapping a connector potential at the connector contact element to determine the temperature of the contact point. In an alternative of the first example, the connector may comprise a mating connector contact probe for determining a mating connector potential of the mating connector contact element. According to a modification of the first example, the connector may comprise the connector tap of the first example and the mating connector contact probe of the alternative of the first example.

The connector tap and the mating connector contact probe define the two points between which the voltage is measured. The voltage between the two points can be measured directly or indirectly. For example, both points may be directly connected to a voltage measuring device. Alternatively, the potential at both points may be determined relative to a reference potential, such earth or ground. Transmission of a signal containing the potential value of the counterpart can then be wireless or wired.

Here, the connector tap is understood to be in particular an electrical contact to the connector contact element, which enables the potential tap. Here, the mating connector contact probe is understood to mean in particular a means for determining the potential of the mating connector contact element. For example, this means can be a receiving unit that receives the mating connector potential wirelessly or by cable.

It follows that at least the connector potential or the mating connector potential is output by an output unit to an evaluation unit. The evaluation unit is used to determine the temperature of the contact point from the potential difference between the connector potential and the mating connector potential using the above formula (1).

If only the connector potential or the mating connector potential is output, the connector potential or the mating connector potential is measured relative to a reference potential. The missing value, i.e. the mating connector potential or connector potential, does not necessarily have to be measured and can, for example, be a reference value or predefined value that is available to the evaluation unit or is received by the evaluation unit. For example, in the case of an EV, a set point value for the charging voltage relative to the reference potential can be set on the plug or mating connector. This set point can then be used to calculate the temperature in the contact point.

As used herein, an output unit is understood to be a unit that enables signals or data, in this case the connector potential and/or the mating connector potential, to be sent or output by the connector, i.e. to enable communication / interaction of the connector with its 'outside world'.

The evaluation unit comprises a corresponding input for receiving the potential values. If only the connector potential or the mating connector potential is received, the evaluation unit can provide a reference potential, for example.

According to a second example similar to the modification of the first example, the connector includes the connector tap for tapping a connector potential at the connector contact element, and a mating connector contact probe for determining a mating connector potential of the mating connector contact element.

Thus, the potential difference between the connector potential and the mating connector potential at the connector can be determined. Furthermore, the temperature of the contact point can be determined from the determined potential difference. Thus, there are two measured values, the connector potential and the mating connector potential, which are determined or ascertained, and from these the temperature of the contact point is determined. This arrangement is advantageous because both measured potentials of connectors are determined and thus the potential difference can be determined particularly accurately.

According to a third example, in addition to the first or second example, the mating connector contact probe comprises a head portion for releasable contacting the mating connector contact element, the head portion for tapping the mating connector potential. Thus, the potential difference can be determined particularly accurately since the potentials can be compared directly without a reference potential. Furthermore, a head portion makes it possible that only the connector has to be changed in order to determine the potential difference. The mating connector can remain unchanged.

According to a fourth example, in addition to the third example, the head portion comprises a spring member, a sliding member, brush member, or a bracing member.

Herein, a spring member is an element, preferably a metallic component, which can be deformed sufficiently elastically in practical use. The elastic deformation of springs is usually bending or torsion. Thus, the spring enables a secure contact that can also be released.

Here, a sliding member (also referred to as sliding contact) refers to an element that is used to make contact with moving parts. Pairings of copper/copper alloys and graphite can be used, as well as pairings of precious metals or carbon brushes. Pairings of copper and graphite can be advantageous for high voltages, while precious metals can be advantageous for very low power and signal transmission.

One form of the sliding member is the brush member, which has, for example, a carbon brush.

Herein, a bracing member, also referred to as a spring-loaded terminal, refers to an element that is inserted into a mating terminal. In electrical engineering, a terminal is used for the detachable connection or joining of bracing members such as wires, cores and cables. In the clamped-on state, a permanent, safe contact can be ensured.

According to a fifth example, in addition to each of the first to fourth examples, the connector further comprises an evaluation unit for determining the potential difference between the connector potential and the mating connector potential. The connector can thus be more easily connected to infrastructure, such as the EV or a charging structure, since only one signal connection to the potential difference, temperature, or a derived value needs to be provided.

As used herein, an evaluation unit includes, for example, an analog unit such as a voltage measurement unit for determining or detecting a potential difference. Also, the evaluation unit may comprise a digital unit (also referred to as a processor unit) which, for example, determines the temperature value from the potential difference. For this purpose, the processor unit may be connected to a value memory unit that stores predetermined values, such as the resistivity of the contact material $\rho$ and/or the thermal conductivity of the contact material $\lambda$. Furthermore, the processor unit may be connected to a program memory unit that stores predetermined routines for calculating the temperature, such as formula (1).

Furthermore, the evaluation unit may comprise an output unit that outputs signals, for example an instruction to reduce the power transmission in the connector. An interruption is also a form of reduction.

According to a sixth example, in addition to the fifth example, the evaluation unit may have a temperature input for receiving a connector temperature at the connector contact element and/or a mating connector temperature at the mating connector contact element. Thus, a temperature measurement, for example of the temperature T1, can be easily taken into account

According to a seventh example, in addition to each of the first through sixth examples, the connector further comprises a temperature sensor for determining a connector temperature. A temperature sensor may comprise an electrical or electronic component that provides an electrical signal as a measure of temperature. The temperature sensor may be arranged directly on the connector contact element or may be arranged on the connector. The electrical signal may be received, for example, by the evaluation unit in or an evaluation unit outside the connector.

According to an eighth example, in addition to each of the first to seventh examples, the connector further comprises one or more output units for outputting a signal. The signal may thereby comprise a value based on the temperature of the contact point, the potential difference, the connector potential, the mating connector potential, a connector temperature at the connector contact element, and a mating connector temperature at the mating connector contact element. The output unit may output the signal wired or wirelessly. For example, the output signal may be received by an EV or charging infrastructure, wherein the connector is connectable to the EV or charging infrastructure.

Thus, based on the signal indicating excessive temperature in the contact point, an external evaluation unit can interrupt power transmission or reduce power.

According to a ninth example, in addition to each of the first to eighth examples, the connector tap is disposed between a connector tip of the connector contact element and the contact point. Thus, the connector tap contacts the connector contact element in an area where no current flows when the plug is connected to the mating connector.

Additionally or alternatively, the mating connector contact probe contacts the mating connector contact element between a mating connector tip of the mating connector contact element and the contact point. Thus, the mating connector contact probe contacts the connector contact element in an area where no current flows when the plug is connected to the mating connector.

The connector tip is the end of the connector that engages with the mating connector contact element. The mating connector tip is the end of the mating connector that engages with the connector contact element.

Such a measurement allows that the potential difference can be measured offset-free. Otherwise, an offset must be calculated in the calculation of the temperature, which is based on the transmitted current in the connector and a resistance of the connector contact element and/or the mating connector contact element.

According to a tenth example, in addition to each of the first through ninth examples, the connector contact element comprises a pin and the connector tap is guided in the pin. This allows for a space saving arrangement of the connector tap. Further, this arrangement allows the connector potential to be measured in a region where no current flows when the connector is connected to the mating connector.

This arrangement is particularly advantageous if measurements have to be taken on the vehicle side and the pin is provided on the vehicle side. This is particularly useful in markets such as the EU and the US, which require the pin to be located on the vehicle side.

According to an alternative of the tenth example, in addition to each of the first to ninth examples, the connector contact element comprises a socket and the mating connector contact probe is guided through an opening in the socket. This allows for a space saving arrangement of the mating connector contact probe. Furthermore, this arrangement allows the mating connector potential to be measured in a region where no current flows when the connector is connected to the mating connector.

This arrangement is particularly advantageous if measurements have to be taken on the vehicle side and the socket is provided on the vehicle side. An application arises particularly in markets such as JP and CN, which standardize that the socket is arranged on the vehicle side.

According to an eleventh example, in addition to each of the first to tenth examples, the connector further comprises a potential separation. The potential separation serves to galvanically separate a high-voltage circuit from a low-voltage circuit. In the high-voltage circuit, the connector potential is tapped and the mating connector potential is determined. In the low-voltage circuit, the potential difference is evaluated. Potential separation (also galvanic decoupling or galvanic isolation) is the avoidance of electrical conduction between two circuits between which power or signals are to be exchanged. Galvanic isolation usually includes non-electrical coupling at the same time. Various components such as isolation amplifiers, transformers, capacitors, optocouplers, optical fibers or relays can be used for power or signal transmission.

In particular, an optocoupler, a component of optoelectronics, can be used. The optocoupler usually consists of a light-emitting diode (LED) or laser diode (LD) as the optical transmitter and a photodiode or phototransistor as the optical receiver. The transmitter and receiver components are optically coupled to each other in a housing that is opaque from the outside.

Furthermore, the present invention relates to a method for determining a temperature of a contact point of a connector, the connector for electrically contacting a connector contact element with a mating connector contact element of a mating connector at the contact point. For the description of the connector, the connector contact element, the mating connector contact element and the contact point, reference is made to the above description.

In particular, this may be a computer-implemented process.

According to a twelfth example, wherein a connector according to any of the first to eleventh examples may be used, the method comprises:

receiving, from a connector tap, a connector potential of the connector contact element,

receiving, from a mating connector contact probe, a mating connector potential of the mating connector contact element,

determining, by an evaluation unit, based on the connector potential and the mating connector potential, the temperature of the contact point.

For the description of the connector tap, the mating connector contact probe, and the evaluation unit, please refer to the above description.

According to a thirteenth example, in addition to the twelfth example, the method may further comprise: determining, by the evaluation unit, whether the temperature of the contact point is higher than a limit temperature.

In particular, the evaluation unit can determine an excess temperature by comparing the temperature of the contact point with a limit temperature, which is a predefined or predetermined temperature.

According to a fourteenth example, in addition to the thirteenth example, the method may further comprise: Instruction to reduce the power transmission of the connector when the temperature of the contact point is higher than a limit temperature.

The instruction can be given, for example, by the evaluation unit. Herein, a reduction may also include an immediate or time-delayed interruption of the power transmission.

According to a fifteenth example, in addition to the twelfth through fourteenth examples, the method may further comprise:

receiving, from a temperature sensor, an offset temperature of the connector contact element and/or the mating connector contact element, and

determining the temperature of the contact point based on the potential difference and the offset temperature.

Thus, the temperature in the contact point can be determined particularly precisely.

According to a sixteenth example, in addition to the twelfth through fifteenth examples, the method may further comprise:

receiving, from a memory unit, a predetermined value for determining an offset voltage, and

where the temperature of the contact point is determined on the potential difference and the offset voltage.

Thus, even if the potentials are tapped in the current-carrying area, the temperature in the contact point can be determined precisely.

According to a seventeenth example, in addition to the sixteenth example, the offset voltage may be based on a predetermined resistance and a current level, the current level being received from a control device.

Thus, the temperature can be determined particularly accurately.

The device, i.e. the connector, and the method for determining the temperature complement each other. In order to streamline the description, not all features mentioned in the description of the device are repeated in the description of the method. However, features of the device also describe the method and vice versa and can be used to further describe the device and the method.

For a better understanding of the present invention, it will be explained in more detail with reference to the examples of embodiments shown in the following figures. In this context, identical parts are provided with identical reference signs and identical component designations. Furthermore, some features or combinations of features from the different embodiments shown and described may also represent independent, inventive solutions or solutions according to the invention.

It shows:

**Fig. 1** an example of a connector;
**Fig. 2** Sectional view of a connector with a mating connector contact probe according to a first example;
**Fig. 3** Sectional view of a connector with a mating connector contact probe according to a second example;
**Fig. 4** Connector tap corresponding to a first example;
**Fig. 5** Sectional view of a connector with an arrangement of a connector tap and a mating connector contact probe according to a first example;
**Fig. 6** Sectional view of a connector with an arrangement of a connector tap and a mating connector contact probe according to a second example;
**Fig. 7** Sectional view of a connector with a mating connector contact probe according to a third example;
**Fig. 8** Sectional view of a connector with a connector tap according to a second example;
**Fig. 9** Sectional view of a connector with a mating connector contact probe according to a fourth example;
**Fig. 10** Sectional view of a connector with a mating connector contact probe according to a fifth example; and
**Fig. 11** Block diagram of an evaluation unit.

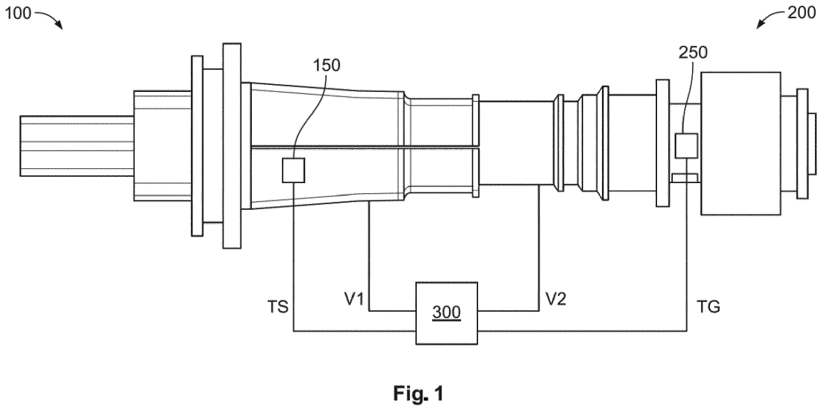

The present invention will now be described with the aid of the figures. Fig. 1 shows a connector 100 for determining a temperature of a contact point. The connector is used to contact a mating connector 200.

The connector 100 comprises a connector contact element, which may be covered by a plug protective housing. Remotely, the connector 100 may comprise a connector tap for tapping a connector potential V1 at the connector contact element. Further, the connector may comprise a temperature sensor 150 for detecting a connector temperature TS. The temperature sensor 150 may be disposed in the connector protective housing or on the connector contact element.

The mating connector 200 comprises a mating connector contact element, which may be covered by a mating connector protective housing. Further, the mating connector 200 may include a mating connector contact probe for determining a mating connector potential V2 of the mating connector contact element. Further, the mating connector 200 may comprise a temperature sensor 250 for determining a mating connector temperature TG. The temperature sensor 250 may be disposed in the mating connector protective housing or on the mating connector contact element.

Further, the connector 100 comprises an output unit for outputting the connector potential V1 and an output unit for outputting the connector temperature TS. It is not shown that the connector 100 may respectively comprise an output unit for outputting the temperature of the contact point, a mating connector potential, or a mating connector temperature.

Further, the mating connector 200 comprises an output unit for outputting the mating connector potential V2 and an output unit for outputting the mating connector temperature TG. Even not shown, the mating connector may comprise an output unit for outputting at least one of the temperature of the contact point, a connector potential, and a connector temperature.

The output units output the signals to an evaluation unit 300. Here, the evaluation unit is shown outside the connector 100 and outside the mating connector 200. However, the evaluation unit 300 can also be arranged in the connector, for example.

The evaluation unit 300 can determine a potential difference U between the connector potential V1 and the mating connector potential V2. Based on the potential difference U, the following can be determined according to formula (1)

$$T_{Contact} = \frac{U^2}{8\rho\lambda} + T_1 \qquad\qquad \text{Formula (1)}$$

the temperature $T_{Contact}$ of the contact point can be determined. Here $T_1$ the temperature at a remote point in the contact piece, for example TS or TG, $U$ the constriction voltage between the contact surface and this remote point, in this case the potential difference determined from V1 and V2, $\rho$ the resistivity of the contact material, and $\lambda$ the thermal conductivity of the contact material. It is therefore advantageous that the at least one temperature sensor is arranged where the voltage is also tapped.

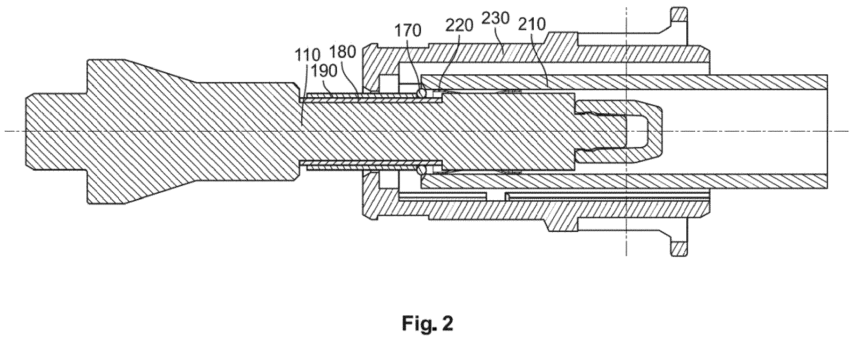

Fig. 2 shows a sectional view of a connector comprising the connector contact element 110 of the connector and the mating connector 200.

The connector contact element 110 is a male part in the form of a pin that comes into plug contact with the mating connector contact element 210, a female part in the form of a socket. In particular, here the mating connector contact element 210 comprises a spring member 220 for electrically contacting the connector contact element 110. Further, both the plug connector and the mating connector may have a housing, such as the mating connector housing 230.

The connector includes a mating connector contact probe 170 for determining a mating connector potential V2 of the mating connector contact element 210. Here, the mating connector contact probe 170 is attached to the connector contact element 110, wherein an insulating layer 180 is provided between the mating connector contact probe 170 and the connector contact element 110. The mating connector contact probe 170 is connected to an evaluation unit not shown in Fig. 2 via an output unit, in this case the measuring line 190.

Here, the mating connector contact probe 170 has as its head portion a sliding contact which protrudes perpendicularly to the mating direction on at least two opposite sides of the connector contact element 110. Advantageously, the mating connector contact probe 170 is formed as a ring element.

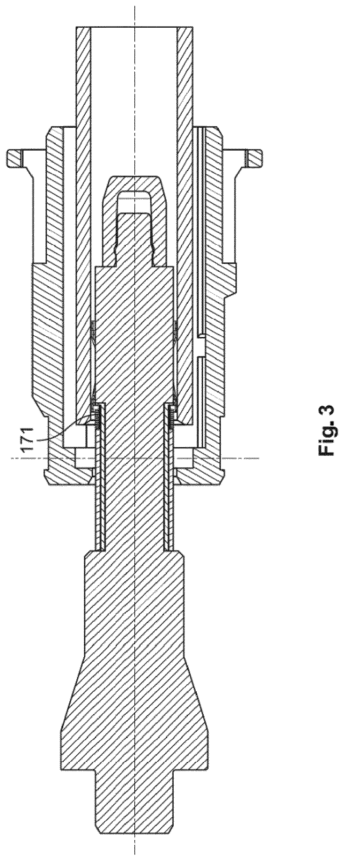

Fig. 3 is similar to Fig. 2. In contrast to Fig. 2, the head portion in Fig. 3 of the mating connector contact probe 171 is a brush member that protrudes perpendicular to the mating direction on at least two opposite sides of the connector contact element. Advantageously, the mating connector contact probe 171 is formed as a ring element.

Figures 2 and 3 show possibilities for a mating connector contact probe comprising a head portion for detachably contacting the mating connector contact element. This head portion is used for tapping the mating connector potential. In particular, the head portion may also comprise a spring member or a bracing member in embodiments not shown.

Figures 2 and 3 do not show the connector tap. The connector potential can be tapped from the outside at the pin, for example.

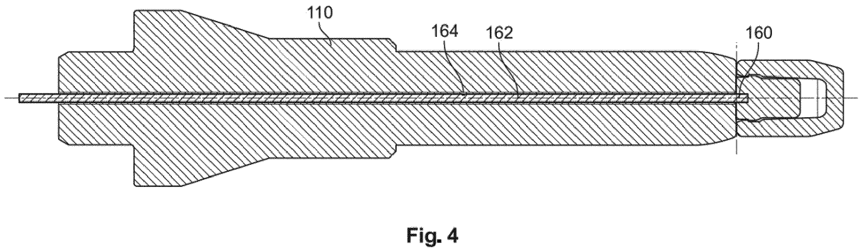

Fig. 4 shows the connector contact element 110 of the connector, wherein the connector contact element 110 is formed as a pin and the connector tap is guided in the pin. In particular, the connector tap includes a sensing tip 160 and a sensing lead 162, wherein an insulation 164 is provided between the sensing lead 162 and the connector contact element 110.

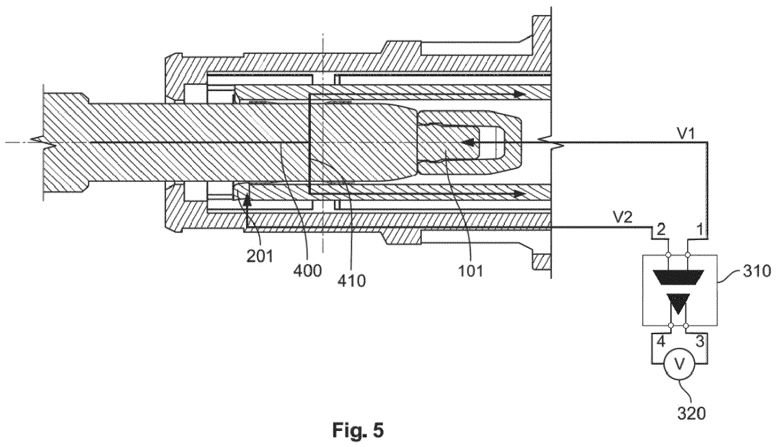

Fig. 5 shows the current flow 400 from the connector 100 to the mating connector 200, the location of the tap of the mating connector potential V2 tapped with a mating connector contact probe such as described in Figs. 2 and 3, and the location of the tap of the connector potential V1 tapped with a connector contact probe such as described in Fig. 4.

As shown in Figures 2 to 5, the connector potential V1 and the mating connector potential V2 are tapped in regions where current does not flow in the connector contact element 110 and the mating connector contact element 210, respectively. In particular, the connector tap is arranged between a connector tip 101 of the connector contact element and the contact point 410. Further, the mating connector contact probe is arranged between a mating connector tip 201 of the mating connector contact element and the contact point 410. The connector tip 101 is inserted into the mating connector tip 201.

This arrangement makes it possible to calculate the temperature according to formula (1). In particular, it is not necessary to take into account that current-carrying areas of the contact elements provide a voltage contribution.

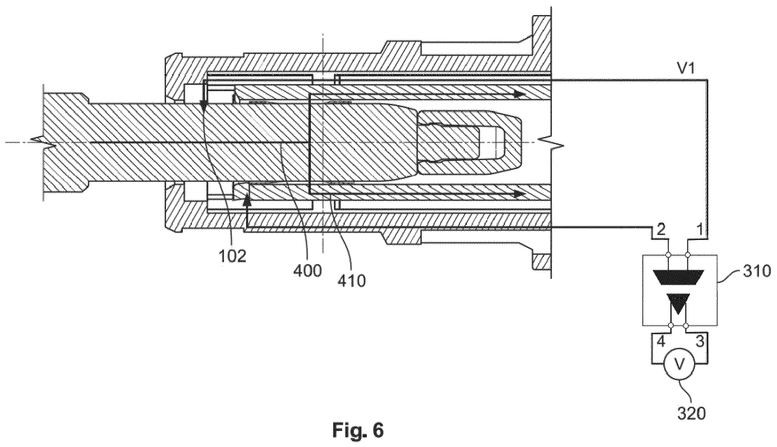

Fig. 6 is similar to Fig. 5, in particular the location for the connector tap is different from Fig. 5. In particular, the connector potential V1 is tapped between a plug end 102 of the connector contact element and the contact point 410.

In this region, current I flows through the connector contact element 110. If it is taken into account that the connector contact element has a finite resistance $R_{plug}$, this can be considered according to $U_{offset} = R_{plug} * I$ in formula (1). This results in:

$$T_{Contact} = \frac{(U + Uoffset)^2}{8\rho\lambda} + T_1 \qquad \qquad \text{Formula (2)}$$

Here it is possible to measure the current level I, to derive it from a set point or to estimate it with a predefined maximum value.

Thus, in both examples, it is possible to determine the temperature of the contact point from the potential difference U between the connector potential V1 and the mating connector potential V2 using formula (1) or formula (2).

Further, as shown in Figures 5 and 6, the connector potential V1 and the mating connector potential V2 are output to an isolation amplifier 310. Not shown is that an amplifier may still be provided before the isolation amplifier 310. A transformer may still be provided to supply power to this amplifier.

The isolation amplifier is an example for galvanic potential separation between a high voltage circuit with terminal points 1 and 2 for tapping the connector potential V1 and for determining the mating connector potential V2. The galvanic potential separation, here the isolation amplifier 310, has terminal points 3 and 4 which are connected to a low-voltage circuit. The low-voltage circuit is used to evaluate the potential difference. The low-voltage circuit may include, for example, a voltage measuring device 320.

The input of such an isolation amplifier or buffer amplifier can be here the connector potential V1 and the mating connector potential V2, i.e. the potential difference U. The output can provide any signal f(U), for example a derived quantity such as voltage, current, frequency or similar. An optocoupler is an example of an isolation amplifier.

The galvanic potential separation may be provided in the connector 100 or outside the connector 100. The galvanic potential separation may be integrated in the evaluation unit 300. On the other hand, the galvanic potential separation may be provided separately from the evaluation unit 300. For example, terminal points 3 and 4 may be a low potential output unit connectable to an evaluation unit 300.

The voltage measurement device 320 may be provided in the connector 100 or outside the connector 100. The voltage measuring device 320 may be integrated in the evaluation unit 300. On the other hand, the voltage measuring device may be provided separately from the evaluation unit 300. For example, the voltage measuring device 320 may comprise a potential difference output unit connectable to an evaluation unit 300.

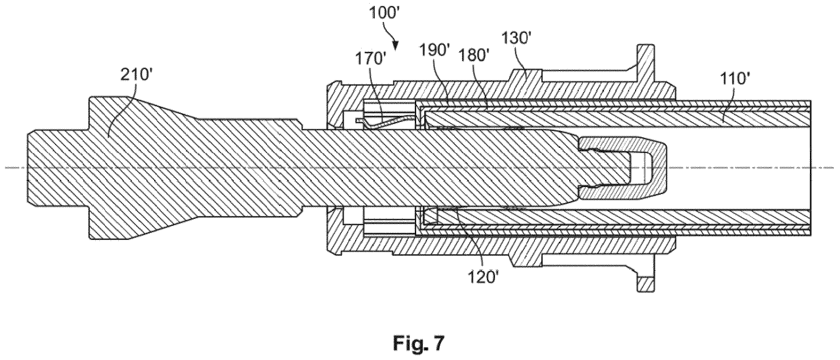

Figures 2 to 6 show solutions in which the connector contact element 110 of the connector 100 is a pin. Figures 7 to 9 show solutions in which the connector contact element 110' of the connector 100' is a socket.

Fig. 7 shows a sectional view of a connector comprising the connector contact element 110' of the connector 100' and the mating connector contact element 210' of the mating connector.

The connector contact element 110' is a female part in the form of a socket that comes into plug contact with the mating connector contact element 210', a male part in the form of a pin. In particular, here the male connector contact element 110' comprises a spring member 120' for electrically contacting the male connector contact element 210'. Further, both the connector and the mating connector may include a housing, such as the connector housing 130'.

The connector includes mating connector contact probe 170' for determining a mating connector potential of the mating connector contact element 210'. Here, the mating connector contact probe 170' is attached to the connector contact element 110', wherein an insulating layer 180' is provided between the mating connector contact probe 170' and the connector contact element 110'. The mating connector contact probe 170' is connected to an evaluation unit, which is not shown, via an output unit, in this case the measuring line 190'.

Here, the mating connector contact probe 170' has a spring contact as its head portion, which protrudes on at least one side of the connector contact element 110' perpendicular to the plugging direction. Advantageously, the mating connector contact probe 170' is manufactured as a stamped and bent part.

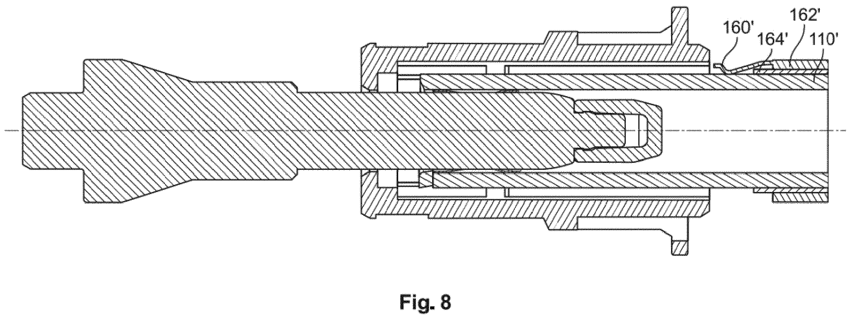

Like Fig. 7, Fig. 8 shows a sectional view of a connector comprising the connector contact element of the connector and the mating connector contact element of the mating connector.

Fig. 8 shows the connector tap, which includes a measuring tip 160' and a measuring lead 162'. In particular, an insulation 164' is provided between the measuring lead 162' and the connector contact element 110'.

Here, the connector tap has a spring contact as measuring tip 160', which protrudes on at least one side of the connector contact element 110' perpendicular to the plug-in direction. Advantageously, the measuring tip 160' is manufactured as a stamped and bent part.

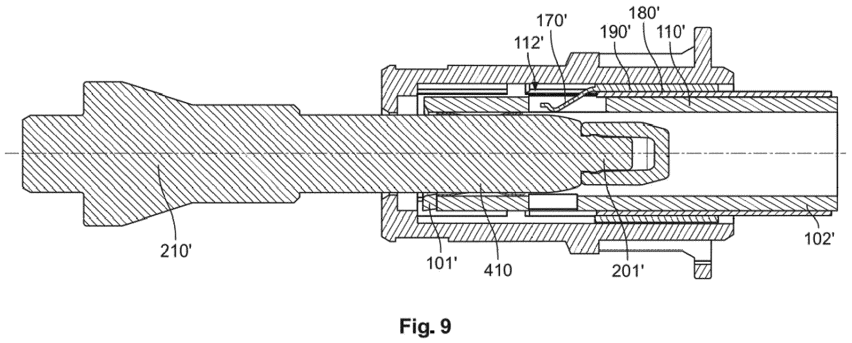

Like Fig. 7, Fig. 9 shows a sectional view of a connector comprising the connector contact element 110' of the connector 100' and the mating connector contact element 210' of the mating connector.

The connector contact element 110' in the form of a socket includes an opening 112'. The opening is disposed between the plug end 102' of the socket and the contact point 410. The plug end 102' faces a connector tip 101', the connector tip 101' receiving the mating connector tip 201'.

As in Fig. 7, the connector of Fig. 9 includes a mating connector contact probe 170' for determining a mating connector potential of the mating connector contact element 210'. Here, the mating connector contact probe 170' is attached to the connector contact element 110', wherein an insulating layer 180' is provided between the mating connector contact probe 170' and the connector contact element 110'. The mating connector contact probe 170' is connected to an evaluation unit, which is not shown, via an output unit, in this case the measuring line 190'.

Unlike in Fig. 7, the mating connector contact probe 170'of Fig. 9 is guided through the opening 112' in the socket. As in Fig. 7, the mating connector contact probe 170' of Fig. 9 has as its head portion a spring contact which protrudes on at least one side of the connector contact element 110' perpendicular to the plugging direction. Advantageously, the mating connector contact probe 170' is manufactured as a stamped-bent part. Not shown here are embodiments in which the mating connector contact probe is a brush member, a sliding element or a bracing member. The opening allows the current flow to be measured offset-free and formula (1) to be applied.

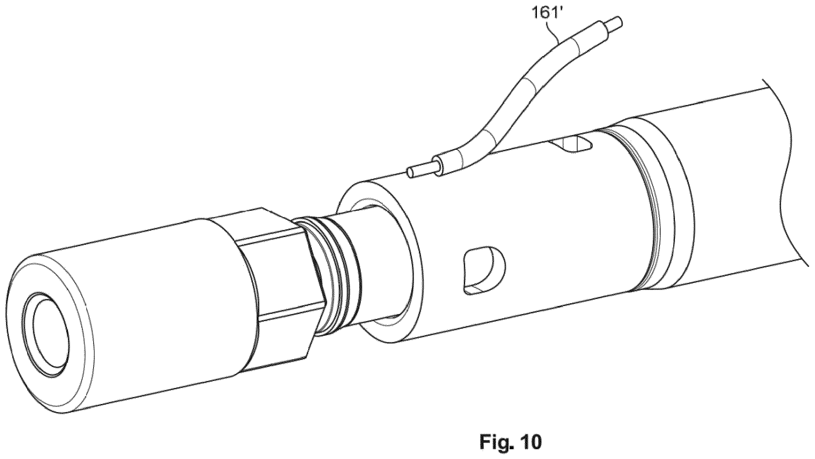

Fig. 10 shows another alternative. The connector tap, as shown in Fig. 8, does not necessarily have to be a spring member. The connector tap can also be provided as a non-detachable contact 161'. In this case, non-releasable means a permanent connection that cannot be released by the user without destroying the connector. The use of a spring may be advantageous for a flexible assembly process. A non-detachable contact 161' may be more stable.

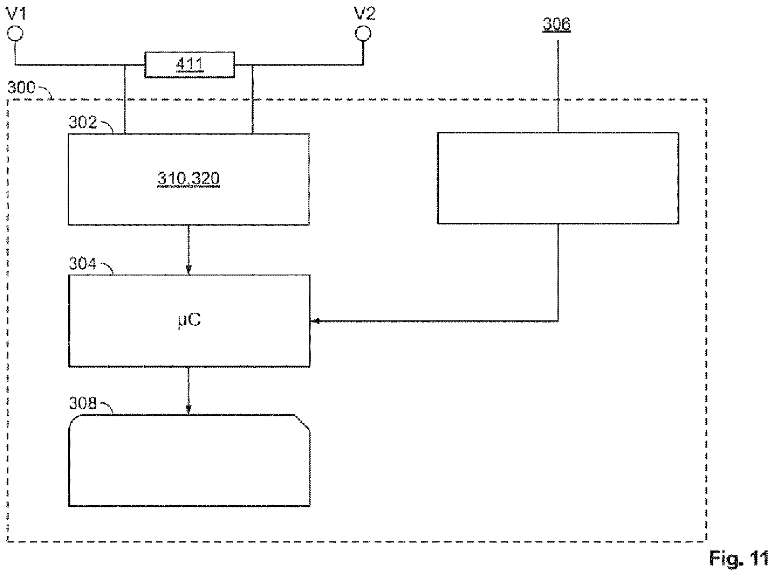

A block diagram showing an evaluation unit 300 is shown in Fig. 11. The evaluation unit receives the connector potential V1 and the mating connector potential V2. The potential difference depends on the resistor 411 at the contact point.

The evaluation unit 300 includes an analog component 302. The analog component may include the galvanic potential separation 310 described above and the voltage measurement device 320. The analog component 302 is used to output the potential difference U. The analog component may also be provided outside the evaluation unit 300, for example in the connector.

The evaluation unit 300 includes a digital component 304. The digital component 304 may include a computing unit, such as a microprocessor. The digital component 304 receives the potential difference U and determines, for example, a temperature in the contact point. The digital component 304 is used to output a signal that depends on the temperature in the contact point. For example, the signal may be the temperature in the contact point. Additionally or alternatively, the signal may include an instruction to a supply unit not shown such that the transmitted power is reduced by the connector. The digital component 302 may also be provided external to the evaluation unit 300, for example in the vehicle or charging station.

The evaluation unit 300 may further comprise a receiving unit 306. The receiving unit 306 may be used to receive a value indicative of the actual value or desired value of the current flow I. Further, the receiving unit 306 may receive temperature values from temperature sensors indicating the temperature TS or TG of the contact elements. If the analog component does not receive the connector potential V1 or the mating connector potential V2 directly via a tap, the receiving unit 306 may receive an appropriate value and generate the potential for the analog component. The receiving unit 306 may also be provided outside the evaluation unit 300.

The evaluation unit 300 includes an output unit 308. The output unit 308 can directly output the signal generated by the digital unit 304 and/or a derived value determined by the analog unit 302, and/or the connector potential V1, and/or the mating connector potential V2, and/or values of the receiving unit, such as TS, TG, I.

By the evaluation unit 300 it is possible to determine the temperature of a contact point of a connector.

The method performed by the evaluation unit or parts of the evaluation unit comprises, receiving, from a connector tap via an analog unit 302, a connector potential V1 of the connector contact element, receiving, from a mating connector contact probe via an analog unit 302, a mating connector potential V2 of the mating connector contact element, and determine, by a digital unit 304, based on the connector potential and the mating connector potential, the temperature of the contact point.

In particular, the method may further comprise:

Rerceiving, from a temperature sensor via the receiving unit 306, an offset temperature of the connector contact element TS and/or the mating connector contact element TG, and

determining, by the digital unit 304, the temperature of the contact point based on the potential difference and the offset temperature.

In particular, the method may further comprise:

receiving, from a memory unit, a predetermined value, for example $R_{connector}$ or $U_{Offset}$, to determine an offset voltage, and

determining, by the digital unit 304, the temperature of the contact point based on the potential difference and the offset voltage.

Further, the method may further comprise:

receiving, via the receiving unit 306, a current level I, and
determining the offset voltage from a predetermined resistance and the received current level I.

In particular, the method may further comprise:
outputting, via the output unit 308, a signal from which the temperature of the contact point can be determined.

**List of reference signs:**

| Reference number | Description |
| --- | --- |
| 100, 100' | Connector |
| 101, 101' | Connector tip |
| 102' | Plug end |
| 110, 110' | Connector contact element |
| 112' | Opening |
| 120' | Spring member |
| 130' | Plug housing |
| 150, 250 | Temperature sensor |
| 160, 160', 161' | Connector tap, measuring tip |
| 162, 162' | Measuring line |
| 164, 164' | Insulation |
| 170, 171, 170' | Mating connector contact probe |
| 180, 180' | Insulating layer |
| 190, 190' | Measuring line |
| V1 | Connector potential |
| TS | Connector temperature |
| 200 | Mating connector |
| 201 | Mating connector tip |
| 210, 210' | Mating connector contact element |
| 220 | Spring member |
| 230 | Mating connector housing |
| V2 | Mating connector potential |
| TG | Mating connector temperature |
| U | Potential difference |
| 300 | Evaluation unit |
| 302 | Analog component |
| 304 | Digital component |
| 306 | Receiver unit |
| 308 | Output unit |
| 310 | Isolation amplifier |

(continued)

| Reference number | Description |
|---|---|
| 320 | Voltmeter |
| 400 | Current flow |
| 410 | Contact point |

**Claims**

1. Connector (100) having an output unit (308) for connecting to an evaluation unit (300) for determining a temperature ($T_{Contact}$) of a contact point, the connector (100) comprising:

a connector contact element (110, 110') for electrically contacting the connector (100) with a mating connector contact element (210) of a mating connector (200) at the contact point,
connector tap (160, 160') for tapping a connector potential (V1) at the connector contact element (110, 110'),
mating connector contact probe (170, 170') for determining a mating connector potential (V2) of the mating connector contact element (210),
wherein the evaluation unit (300) is configured to determine the temperature ($T_{Contact}$) of the contact point from a potential difference (U) between the connector potential (V1) and the mating connector potential (V2).

2. Connector (100) according to claim 1, wherein the mating connector contact probe (170, 170') comprises a head portion for releasable contacting the mating connector contact element (210), the head portion for tapping the mating connector potential (V2).

3. Connector (100) of claim 2, wherein the head portion comprises a spring member (170'), a sliding member (170), a brush member (171), or a bracing member.

4. Connector (100) according to any one of the preceding claims, further comprising the evaluation unit (300) for determining the potential difference (U) between the connector potential (V1) and the mating connector potential (V2).

5. Connector (100) according to claim 4, wherein the evaluation unit (300) comprises an input (306) for receiving a value of the current level (I) through the connector contact element (110, 110'), a connector temperature (TS) at the connector contact element (110, 110') and/or a mating connector temperature (TG) at the mating connector contact element (210).

6. Connector (100) according to any one of the preceding claims, further comprising a temperature sensor (150, 250) for determining a connector temperature and/or a mating connector temperature.

7. Connector (100) according to any one of the preceding claims, further comprising an output unit (308) for outputting a signal, wherein the signal is based on at least the temperature of the contact point, the potential difference (U), the connector potential (V1), the mating connector potential (V2), a connector temperature (TS) at the connector contact element (110, 110'), and a mating connector temperature (TG) at the mating connector contact element (210).

8. Connector (100) according to any one of the preceding claims, wherein the connector tap (160, 160') is disposed between a connector tip (101) of the connector contact element (110, 110') and the contact point and/or wherein the mating connector contact probe (170, 170') is disposed between a mating connector tip (201) of the mating connector contact element (210) and the contact point.

9. Connector (100) according to any one of the preceding claims, wherein the connector contact element (110) comprises a pin and the connector tap (160) is guided in the pin.

10. Connector (100) of any one of claims 1 to 8, wherein the connector contact element (110') comprises a socket and the mating connector contact probe (170') is passed through an opening (112') in the socket.

11. Connector (100) according to any one of the preceding claims, further comprising a potential separation for galvanically separating a high-voltage circuit for tapping the connector potential (V1) and for determining the mating connector potential (V2) from a low-voltage circuit, the low-voltage circuit for evaluating the potential difference (U), in particular wherein the potential separation comprises an isolation amplifier (310).

12. Connector (100) having an output unit (308) for connecting to an evaluation unit (300) for monitoring a temperature of a contact point comprising the connector (100):

connector contact element (110) for electrically contacting the connector (100) with a mating connector contact element (210) of a mating connector (200) at the contact point,
furthermore comprising:

connector tapping (160, 160') for tapping a connector potential (V1) at the connector contact element (110, 110'), and the output unit (308) for outputting the connector potential (V1) to the evaluation unit (300), the evaluation unit (300) for determining the temperature of the contact point from the connector potential (V1) and a mating connector potential (V2) of the mating connector (200);
and/or
mating connector contact probe (170, 170') for determining a mating connector potential (V2) of the mating connector contact element (210), and the output unit (308) for outputting the mating connector potential (V2) to the evaluation unit (300), the evaluation unit (300) for determining the temperature of the contact point from the mating connector potential (V2) and a connector potential (V1) of the plug (100).

13. A method of determining a temperature of a contact point of a connector (100), the connector (100) for electrically contacting a connector contact element (110, 110') with a mating connector contact element (210) of a mating connector (200) at the contact point, the method comprising,

receiving, from a connector tap (160, 160'), a connector potential (V1) of the connector contact element (110, 110'),
receiving, from a mating connector contact probe (170, 170'), a mating connector potential (V2) of the mating connector contact element (210),
determining, by an evaluation unit (300), based on the connector potential (V1) and the mating connector potential (V2), the temperature of the contact point.

14. The method of claim 13, wherein the method further comprises:

receiving, from a temperature sensor (150, 250), an offset temperature (T1) of the connector contact element (110, 110') and/or the mating connector contact element (210), and
where the temperature of the contact point is determined on the potential difference (U) and the offset temperature (T1).

15. The method of any one of claims 13 to 14, wherein the method further comprises,

receiving, from a memory unit, a predetermined value ($R_{connector}$, $U_{Offset}$) for determining an offset voltage ($U_{Offset}$), and
where the temperature of the contact point is determined on the potential difference (U) and the offset voltage ($U_{Offset}$),
preferably, wherein the offset voltage ($U_{Offset}$) is based on a predetermined resistance ($R_{connector}$) and a current level (I), the current level (I) being received from a control device.

Fig. 1

Fig. 2

EP 4 379 962 A1

171

Fig. 3

15

Fig. 4

Fig. 5

Fig. 6

Fig. 7

Fig. 8

**Fig. 9**

EP 4 379 962 A1

161'

Fig. 10

V1  V2

411

300

302  310.320

304  μC

306

308

Fig. 11

Europäisches
Patentamt
European
Patent Office
Office européen
des brevets

# EUROPEAN SEARCH REPORT

**Application Number**

EP 23 21 2847

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2018 009749 B4 (TE CONNECTIVITY GERMANY GMBH [DE]) 20 October 2022 (2022-10-20) * figures 1-3 * * paragraphs [0035] - [0041] * | 1-15 | INV. H01R11/18 H01R13/66 |
| A | DE 10 2010 045131 A1 (MAGNA E CAR SYSTEMS GMBH & CO [AT]) 15 March 2012 (2012-03-15) * figures 1-4 * * paragraphs [0031] - [0043] * | 1-15 | |
| A | DE 10 2020 201240 A1 (TE CONNECTIVITY GERMANY GMBH [DE]) 5 August 2021 (2021-08-05) * figures 1-16 * * paragraphs [0027] - [0053] * | 1-15 | |
| A | DE 10 2015 206840 A1 (BAYERISCHE MOTOREN WERKE AG [DE]) 20 October 2016 (2016-10-20) * figures 1, 2 * * paragraphs [0028] - [0035] * | 1-15 | |
| A | US 2020/149981 A1 (KOEPPL MAGNUS [DE] ET AL) 14 May 2020 (2020-05-14) * figures 1-3 * * pages 1-4 * | 1-15 | TECHNICAL FIELDS SEARCHED (IPC) H01R G01K G01R B60L |

The present search report has been drawn up for all claims

| Place of search | Date of completion of the search | Examiner |
|---|---|---|
| The Hague | 25 March 2024 | Kandyla, Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2847

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2024

| Patent document cited in search report | Publication date | Patent family member(s) | | Publication date |
|---|---|---|---|---|
| DE 102018009749 B4 | 20-10-2022 | NONE | | |
| DE 102010045131 A1 | 15-03-2012 | NONE | | |
| DE 102020201240 A1 | 05-08-2021 | CN | 113206402 A | 03-08-2021 |
| | | DE | 102020201240 A1 | 05-08-2021 |
| | | EP | 3859908 A1 | 04-08-2021 |
| | | JP | 2021125466 A | 30-08-2021 |
| | | KR | 20210098370 A | 10-08-2021 |
| | | US | 2021242636 A1 | 05-08-2021 |
| DE 102015206840 A1 | 20-10-2016 | CN | 107454877 A | 08-12-2017 |
| | | DE | 102015206840 A1 | 20-10-2016 |
| | | US | 2018050599 A1 | 22-02-2018 |
| | | WO | 2016166156 A1 | 20-10-2016 |
| US 2020149981 A1 | 14-05-2020 | CN | 110546841 A | 06-12-2019 |
| | | DE | 102017206094 A1 | 11-10-2018 |
| | | EP | 3610543 A1 | 19-02-2020 |
| | | PL | 3610543 T3 | 16-08-2022 |
| | | US | 2020149981 A1 | 14-05-2020 |
| | | WO | 2018188917 A1 | 18-10-2018 |

EPO FORM P0459

For more details about this annex : see Official Journal of the European Patent Office, No. 12/82